# EUROPÄISCHE PATENTANMELDUNG

(11) **EP 4 481 955 A1**
(43) Veröffentlichungstag der Anmeldung: **25.12.2024**
(21) Anmeldenummer: 24176019.8
(22) Anmeldetag: 15.05.2024
(51) Int. Cl.: H01R 13/46, G06K 19/06, H01R 13/629, H01R 13/641, H01R 43/26

(54) **SICHERUNGSVORRICHTUNG MIT ANZEIGEELEMENT UND ORIENTIERUNGSELEMENTEN**

(30) Priorität: 06.06.2023 DE 102023114793
(71) Anmelder: Lisa Dräxlmaier GmbH, 84137 Vilsbiburg (DE)
(72) Erfinder: Wimmer, Stefan, 84098 Hohenthann (DE); Wilhelm, Sebastian, 66625 Nohfelden (DE); Neumayer, Franziska, 84144 Geisenhausen (DE)

(57) **Zusammenfassung**

Die Offenbarung betrifft eine Sicherungsvorrichtung (100) zur Sicherung einer Verriegelung eines Verriegelungselements (110), wobei die Sicherungsvorrichtung (100) Folgendes umfasst: ein Verriegelungselement (110), das von einer ersten Verriegelungsstellung (111) in eine zweite Verriegelungsstellung (112) bewegbar ist, wobei das Verriegelungselement (110) in der zweiten Verriegelungsstellung (112) eine Verriegelung bewirkt; und ein Anzeigeelement (120) zum Anzeigen einer Information, wobei das Anzeigeelement (120) in der ersten Verriegelungsstellung stets sichtbar und nicht verdeckt ist, wobei das Anzeigeelement (120) einen oder mehrere Orientierungselemente (212) zum Markieren einer Position des Anzeigeelements (120) aufweist, wobei das Anzeigeelement (120) über die ein oder mehreren Orientierungselemente (212) erfassbar ist; wobei die ein oder mehreren Orientierungselemente (212) in der ersten Verriegelungsstellung (111) des Verriegelungselements (110) zumindest teilweise unkenntlich gemacht sind, so dass das Anzeigeelement (120) nicht erfassbar ist; und wobei die ein oder mehreren Orientierungselemente (212) in der zweiten Verriegelungsstellung (112) des Verriegelungselements (110) kenntlich gemacht sind, so dass das Anzeigeelement (120) erfassbar ist.

## Beschreibung

### Technisches Gebiet

Die vorliegende Erfindung betrifft eine Sicherungsvorrichtung mit Anzeigeelement und Orientierungselementen. Die Sicherungsvorrichtung dient zur Sicherung einer Verriegelung eines Verriegelungselements bzw. zur "Steckerpositions-Kontrolle" oder "Connector Position Assurance (CPA)" und ist zur Sicherung einer Verriegelung eines Steckergehäuses an einem Gegen-Steckergehäuse einsetzbar. Insbesondere betrifft die Erfindung eine CPA mit DMC (Data Matrix Code), bei dem die Orientierungselemente gesteuert werden.

### Stand der Technik

CPAs ("Connector Position Assurance") sollen verhindern, dass sich ein an einem Gegen-Steckergehäuse verrastetes Steckergehäuse unbeabsichtigt von dem Gegen-Steckergehäuse löst, was beispielsweise aufgrund von Vibrationen, temperaturbedingter Ausdehnung oder Schrumpfung, das Ziehen an einem im Steckergehäuse untergebrachten Kabel oder andere mechanische Einwirkungen passieren kann. Die CPA ist dafür zuständig als letztes zu bedienendes Element den Stecker mit seinem Gegenstück zu verriegeln. Um hier ein sicheres Verriegeln zu gewährleisten, wird gefordert, dass der finale Zustand der Verriegelung durch ein scanbares Element erfasst wird und dieses Element nur lesbar sein darf, wenn die CPA final geschlossen ist.

### Beschreibung der Erfindung

Eine Aufgabe der Erfindung ist es daher, eine geeignete Vorrichtung zu schaffen, mit der zuverlässig erkannt werden kann, ob eine Verriegelung vorliegt oder nicht, insbesondere für Stecker, bei denen eine CPA-Verriegelung erforderlich ist.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Durch die Anforderung, dass der Stecker einen hohen Automatisierungsgrad in Herstellung und Konfektionierung benötigt ist die Verwendung eines scanbaren Elementes zwingend notwendig als Kontrollfunktion. Die hier vorgestellte Erfindung betrifft eine Sicherungsvorrichtung mit einem Anzeigeelement, das ein oder mehrere Orientierungselemente aufweist, welches als scanbares Element genutzt werden kann, um somit eine zuverlässige Kontrolle des Stecker-Herstellungsprozesses zu gewährleisten und ein Scannen des Stecksystems im zusammengebauten Zustand zu ermöglichen. Die hier vorgestellte Lösung kann auf verschiedene Stecksysteme angewendet werden und lässt sich leicht von einem Stecksystem auf ein anderes Stecksystem adaptieren.

Grundprinzip der erfinderischen Lösung ist die Steuerung der Orientierungselemente bzw. Positionsmarker eines DMCs. Der DMC wird mit einem umlaufenden schwarzen Rahmen auf der CPA aufgebracht. Durch Betätigen der CPA wird diese unter den Bügel geschoben. In dem Bügel befindet sich eine Aussparung. Diese Aussparung ist so ausgelegt, dass die Orientierungselemente wieder klar erkennbar sind. Der DMC wird nicht verdeckt. Er wird lediglich so dargestellt, dass die Orientierungselemente nicht erkennbar sind in Stellung 1 bzw. der ersten Verriegelungsstellung. In einer zweiten Variante wird um die Orientierungselemente am DMC ein zusätzlicher Rand geschoben, um die Erkennung zu verschleiern.

Ein Hauptmerkmal der Erfindung ist die Steuerung der Erfassbarkeit durch Manipulation der Orientierungselemente. Der DMC ist immer vollständig dargestellt, allerdings können die Orientierungselemente nicht erfasst werden durch einen zusätzlichen schwarzen Rahmen, der sich um den DMC befindet.

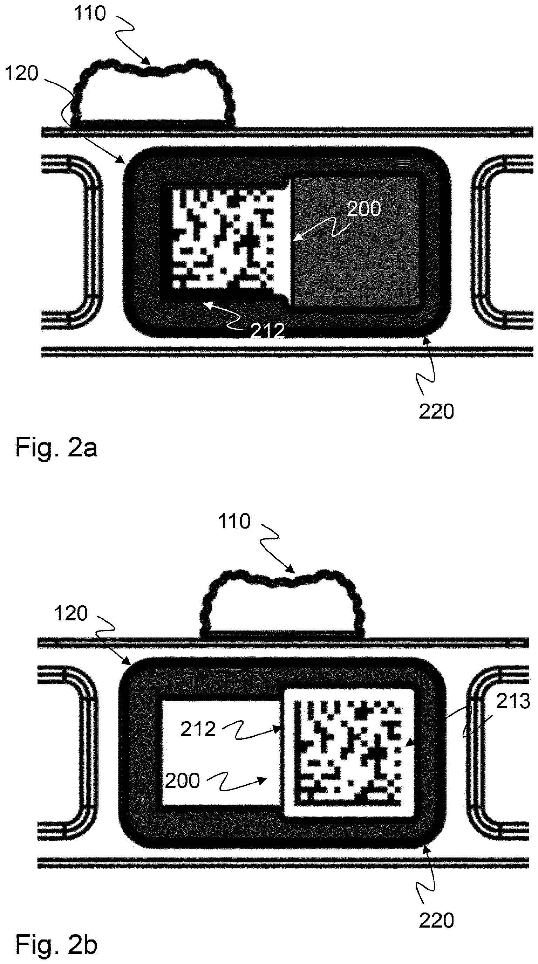

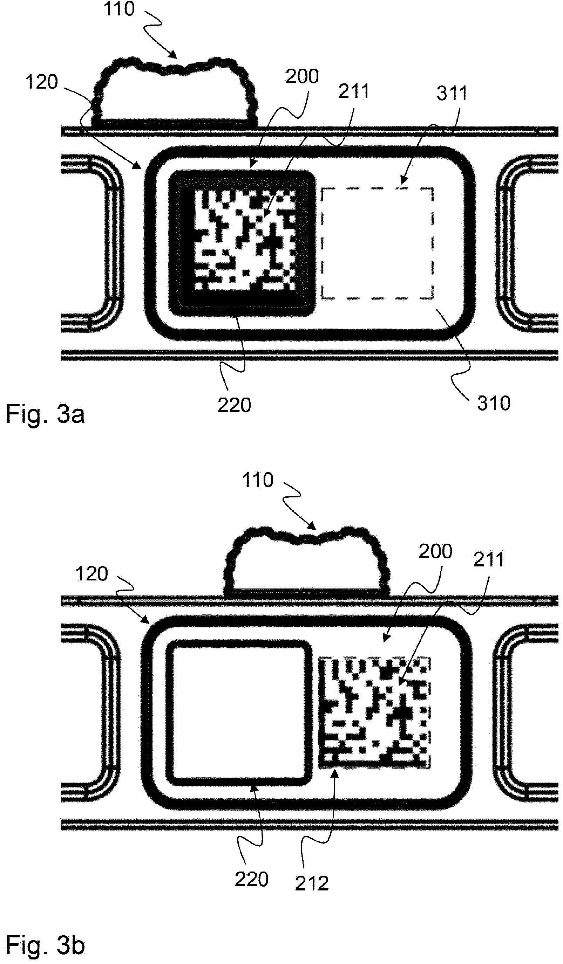

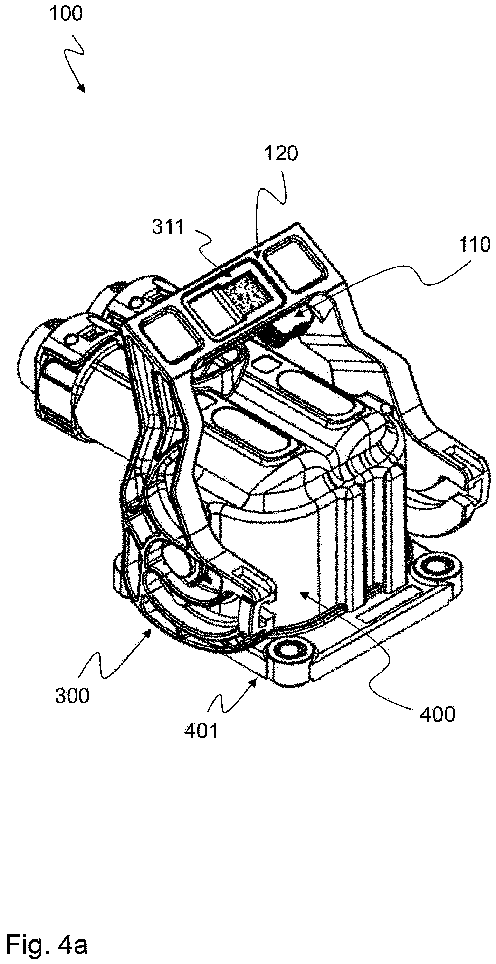

Das Grundprinzip liegt in der Steuerung der Orientierungselemente eines DMCs, wie unten zu den Figuren 2a und 2b sowie 3a und 3b näher beschrieben. Die Orientierungselemente eines DMCs müssen immer klar erkennbar sein. Wenn diese manipuliert werden, wie der DMC in Figur 2a oder 3a, ist dieser nicht erfassbar. Dieses Grundprinzip kann auf die Funktionsweise einer CPA übertragen werden, wie unten zu den Figuren 4a bis 4c näher beschrieben. Der DMC wird mit einem umlaufenden schwarzen Rahmen auf der CPA aufgebracht. Durch Betätigen der CPA wird diese unter den Bügel geschoben. In dem Bügel befindet sich eine Aussparung. Diese Aussparung ist so ausgelegt, dass die Orientierungselemente wieder klar erkennbar sind. In einer zweiten Variante (siehe Figuren 3a und 3b) wird um die Orientierungselemente am DMC ein zusätzlicher Rand geschoben, um die Erkennung zu verschleiern.

Gemäß einem ersten Aspekt wird die oben beschriebene Aufgabe gelöst durch eine Sicherungsvorrichtung zur Sicherung einer Verriegelung eines Verriegelungselements, wobei die Sicherungsvorrichtung Folgendes umfasst: ein Verriegelungselement, das von einer ersten Verriegelungsstellung in eine zweite Verriegelungsstellung bewegbar ist, wobei das Verriegelungselement in der zweiten Verriegelungsstellung eine Verriegelung bewirkt; und ein Anzeigeelement zum Anzeigen einer Information, wobei das Anzeigeelement in der ersten Verriegelungsstellung stets sichtbar und nicht verdeckt ist, wobei das Anzeigeelement einen oder mehrere Orientierungselemente zum Markieren einer Position des Anzeigeelements aufweist, wobei das Anzeigeelement über die ein oder mehreren Orientierungselemente erfassbar ist; wobei die ein oder mehreren Orientierungselemente in der ersten Verriegelungsstellung des Verriegelungselements zumindest teilweise unkenntlich gemacht sind, so dass das Anzeigeelement nicht erfassbar ist; und wobei die ein oder mehreren Orientierungselemente in der zweiten Verriegelungsstellung des Verriegelungselements kenntlich gemacht sind, so dass das Anzeigeelement erfassbar ist.

Eine solche Sicherungsvorrichtung bietet den technischen Vorteil, dass ein sicheres und zuverlässiges Erkennen einer Verriegelung möglich ist. Das Anzeigeelement lässt sich über ein scanbares Element erfassen, so dass eine zuverlässige automatische Erkennung der Stellung des Verriegelungselements möglich ist. Damit lässt sich insbesondere eine automatische Erfassung des Zustands von Steckern, bei denen eine CPA-Verriegelung erforderlich ist, durchführen. Die Sicherungsvorrichtung erfüllt somit die Anforderungen, die an eine CPA-Verriegelung gestellt werden.

Gemäß einer beispielhaften Ausführungsform der Sicherungsvorrichtung sind die ein oder mehreren Orientierungselemente in der ersten Verriegelungsstellung unkenntlich gemacht, ohne die ein oder mehreren Orientierungselemente zu verdecken.

Dies bietet den technischen Vorteil, dass die Orientierungselemente noch sichtbar sind und nicht verdeckt werden. Es wird somit kein Mechanismus benötigt, der die Orientierungselemente verdeckt.

Gemäß einer beispielhaften Ausführungsform der Sicherungsvorrichtung weist das Anzeigeelement ein Erkennungsmerkmal mit einem Datenbereich zum Erfassen des Erkennungsmerkmals auf, wobei die ein oder mehreren Orientierungselemente an einem Rand des Datenbereichs angeordnet sind; und wobei das Erkennungsmerkmal bei einer zumindest teilweisen Unkenntlichmachung der Orientierungselemente nicht mehr erfassbar ist. Das Erkennungsmerkmal kann beispielsweise ein Code sein, zum Beispiel ein ein-, zwei- oder dreidimensionaler Code.

Dies bietet den technischen Vorteil, dass die Orientierungselemente leicht unkenntlich gemacht werden können, wenn sie sich am Rand des Erkennungsmerkmals befinden, und dass über die Orientierungselemente sich das Erkennungsmerkmal auf effiziente Weise unkenntlich machen lässt.

Gemäß einer beispielhaften Ausführungsform der Sicherungsvorrichtung weist das Erkennungsmerkmal einen um den Datenbereich und die Orientierungselemente umlaufenden Ruhebereich auf, wobei der Ruhebereich in der ersten Verriegelungsstellung des Verriegelungselements zumindest teilweise verdeckt ist und das Erkennungsmerkmal dadurch nicht mehr kenntlich ist.

Dies bietet den technischen Vorteil, dass die Orientierungselemente sich leicht über ein Verdecken des Ruhebereichs unkenntlich machen lassen. Es kann beispielsweise schon ausreichen, nur einen Teil des Ruhebereichs zu verdecken oder zu verändern, um die Orientierungselemente unkenntlich zu machen.

Gemäß einer beispielhaften Ausführungsform der Sicherungsvorrichtung weist das Anzeigeelement einen um das Erkennungsmerkmal umlaufenden Rand auf, der die ein oder mehreren Orientierungselemente unkenntlich macht; wobei in der zweiten Verriegelungsstellung der Rand von einem Rahmen verdeckt ist, der die ein oder mehreren Orientierungselemente kenntlich macht.

Dies bietet den technischen Vorteil, dass der umlaufende Rand, der beispielsweise auf dem Ruhebereich des Erkennungsmerkmals liegt, jedoch nicht auf den Orientierungselementen selber, bereits die Orientierungselemente unkenntlich macht. Der Rahmen kann dann auf den Rand gelegt werden, um so den Ruhebereich wieder herzustellen und die Orientierungselemente wieder erkennbar zu machen.

Gemäß einer beispielhaften Ausführungsform der Sicherungsvorrichtung weist der Rand eine gleiche oder ähnliche Farbe wie die Orientierungselemente auf; und der Rahmen weist eine Farbe auf, die in Kontrast zu der Farbe des Rands steht.

Dies bietet den technischen Vorteil, dass der Rand die Orientierungselemente unkenntlich macht und der Rahmen die Orientierungselemente wieder kenntlich macht.

Gemäß einer beispielhaften Ausführungsform der Sicherungsvorrichtung umfasst das Erkennungsmerkmal einen Code, beispielsweise einen Data Matrix Code, DMC.

Der Data Matrix Code ist einer der bekanntesten 2D-Codes und lässt sich für dauerhafte und robuste Direktbeschriftungen einsetzen. Der DMC ist in der Größe variabel und lässt somit eine Vielzahl von Symbol-Elementen zu.

Gemäß einer beispielhaften Ausführungsform der Sicherungsvorrichtung ist das Anzeigeelement an dem Verriegelungselement angebracht und eine Bewegung des Verriegelungselements in die zweite Verriegelungsstellung macht das Anzeigeelement erfassbar.

Dies bietet den technischen Vorteil, dass sich die zweite Verriegelungsstellung, welche mit einer Verriegelungswirkung verbunden ist, effizient anzeigen und erfassen lässt.

Gemäß einer beispielhaften Ausführungsform der Sicherungsvorrichtung ist das Anzeigeelement erkennbar, zum Beispiel mit einem Lesegerät lesbar oder mit den Augen erkennbar, wenn die ein oder mehreren Orientierungselemente nicht zumindest teilweise unkenntlich gemacht sind.

Dies bietet den technischen Vorteil, dass der Zustand des Verriegelungselements sich sicher und zuverlässig mit einem Lesegerät, beispielsweise einem Scanner, bestimmen lässt oder sich einfach visuell erkennen lässt. Damit kann eine automatisierte Montage von Stecksystemen effizient kontrolliert werden und es können visuelle Stichproben gemacht werden.

Gemäß einer beispielhaften Ausführungsform der Sicherungsvorrichtung ist die Sicherungsvorrichtung ausgebildet, eine Steckerpositions-Sicherung (CPA) zur Sicherung einer Verriegelung eines Steckergehäuses an einem Gegen-Steckergehäuse vorzunehmen.

Dies bietet den technischen Vorteil, dass der Zustand der CPA sich sicher durch ein scanbares Element erfassen lässt, welches nur dann lesbar ist, wenn die CPA final geschlossen ist.

Gemäß einer beispielhaften Ausführungsform der Sicherungsvorrichtung umfasst die Sicherungsvorrichtung ferner: ein Spannelement zum Einspannen des Steckergehäuses in das Gegen-Steckergehäuse, wobei das Spannelement von einer offenen Spannelementstellung, in der das Steckergehäuse in das Gegen-Steckergehäuse einführbar ist, in eine geschlossene Spannelementstellung, in der das Steckergehäuse elektrisch kontaktierend mit dem Gegen-Steckergehäuse fixiert ist, bewegbar ist; wobei das Verriegelungselement an dem Spannelement angebracht ist und ausgebildet ist, das Spannelement zu verriegeln oder zu entriegeln.

Dies bietet den technischen Vorteil, dass das Anzeigeelement zuverlässig eine Information, zum Beispiel eine Information über eine Verriegelung oder Nicht-Verriegelung des Spannelements, beispielsweise eines Bügels, anzeigt, so dass der Zustand des Spannelements sich mit einem scanbaren Element oder auch mit den Augen effizient erfassen lässt.

Gemäß einer beispielhaften Ausführungsform der Sicherungsvorrichtung ist das Verriegelungselement in der geschlossenen Spannelementstellung von der ersten Verriegelungsstellung in die zweite Verriegelungsstellung bewegbar und ist ausgebildet, in der zweiten Verriegelungsstellung das Spannelement in der geschlossenen Spannelementstellung zu verriegeln, und in der ersten Verriegelungsstellung das Spannelement für eine Bewegung in die offene Spannelementstellung zu entriegeln.

Dies bietet den technischen Vorteil, dass ein sicheres Verbinden des Steckergehäuses mit dem Gegen-Steckergehäuse über das Spannelement gewährleistet ist. Die Sicherungsvorrichtung erfüllt somit die Anforderungen, die an eine CPA-Verriegelung gestellt werden.

Gemäß einer beispielhaften Ausführungsform der Sicherungsvorrichtung weist das Spannelement eine Aussparung auf; wobei das Anzeigeelement an dem Spannelement angebracht ist; und wobei bei einer Bewegung des Verriegelungselements in die zweite Verriegelungsstellung das Anzeigeelement unter die Aussparung des Spannelements bewegt wird, und damit die ein oder mehreren Orientierungselemente kenntlich macht, so dass das Anzeigeelement erfassbar ist.

Dies bietet den technischen Vorteil, dass das Spannelement als Rahmen dienen kann, der sich über den Rand um den zwei-dimensionalen Code schieben lässt, um so die Orientierungselemente wieder kenntlich zu machen.

Gemäß einem zweiten Aspekt wird die oben beschriebene Aufgabe gelöst durch eine Steckverbindung mit einem Steckergehäuse und einem Gegen-Steckergehäuse, die über eine Sicherungsvorrichtung gemäß dem ersten Aspekt miteinander verbunden und gesichert sind.

Gemäß einem dritten Aspekt wird die oben beschriebene Aufgabe gelöst durch ein Sicherungssystem umfassend eine Sicherungsvorrichtung gemäß dem ersten Aspekt und ein Lesegerät, wobei das Lesegerät ausgebildet ist, das Anzeigeelement zu erfassen, wenn sich das Verriegelungselement in der zweiten Verriegelungsstellung befindet, um eine Verriegelung zu erkennen.

Gemäß einer beispielhaften Ausführungsform des Sicherungssystems ist das Lesegerät ausgebildet, das Anzeigeelement nur dann zu erfassen, wenn sich das Verriegelungselement in der zweiten Verriegelungsstellung befindet und nur in dieser Stellung eine korrekte Verriegelung zu erfassen.

### Kurze Figurenbeschreibung

Im Folgenden wird die Erfindung anhand von Ausführungsbeispielen und den Figuren näher beschrieben. Es zeigen:
- Fig. 1: eine schematische Darstellung der Zustände einer erfindungsgemäßen Sicherungsvorrichtung 100;
- Fig. 2a: eine 2D-Darstellung eines erfindungsgemäßen Anzeigeelements 120 mit unkenntlich gemachten Orientierungselementen gemäß einer ersten Variante;
- Fig. 2b: eine 2D-Darstellung des Anzeigeelements 120 aus Figur 2a gemäß der ersten Variante, bei dem die Orientierungselemente kenntlich gemacht sind;
- Fig. 3a: eine 2D-Darstellung eines auf der CPA aufgebrachten erfindungsgemäßen Anzeigeelements 120, bei dem die Orientierungselemente unkenntlich gemacht sind, gemäß einer zweiten Variante;
- Fig. 3b: eine 2D-Darstellung des Anzeigeelements 120 aus Figur 3a gemäß der zweiten Variante, bei dem die Orientierungselemente kenntlich gemacht sind;
- Fig. 4a: eine 3D-Darstellung einer geschlossenen Sicherungsvorrichtung 100 umfassend ein Verriegelungselement 110, ein Anzeigeelement 120 gemäß der ersten Variante und ein Spannelement 300 in geschlossener Spannbügelstellung;
- Fig. 4b: eine 3D-Darstellung einer geöffneten Sicherungsvorrichtung 100 umfassend ein Verriegelungselement 110, ein Anzeigeelement 120 gemäß der ersten Variante und ein Spannelement 300 in geöffneter Spannbügelstellung; und
- Fig. 4c: eine 3D-Darstellung einer geöffneten Sicherungsvorrichtung 100 umfassend ein Verriegelungselement 110, ein Anzeigeelement 120 gemäß der zweiten Variante und ein Spannelement 300 in geöffneter Spannbügelstellung.

Die Figuren sind lediglich schematische Darstellungen und dienen nur der Erläuterung der Erfindung. Gleiche oder gleichwirkende Elemente sind durchgängig mit den gleichen Bezugszeichen versehen.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

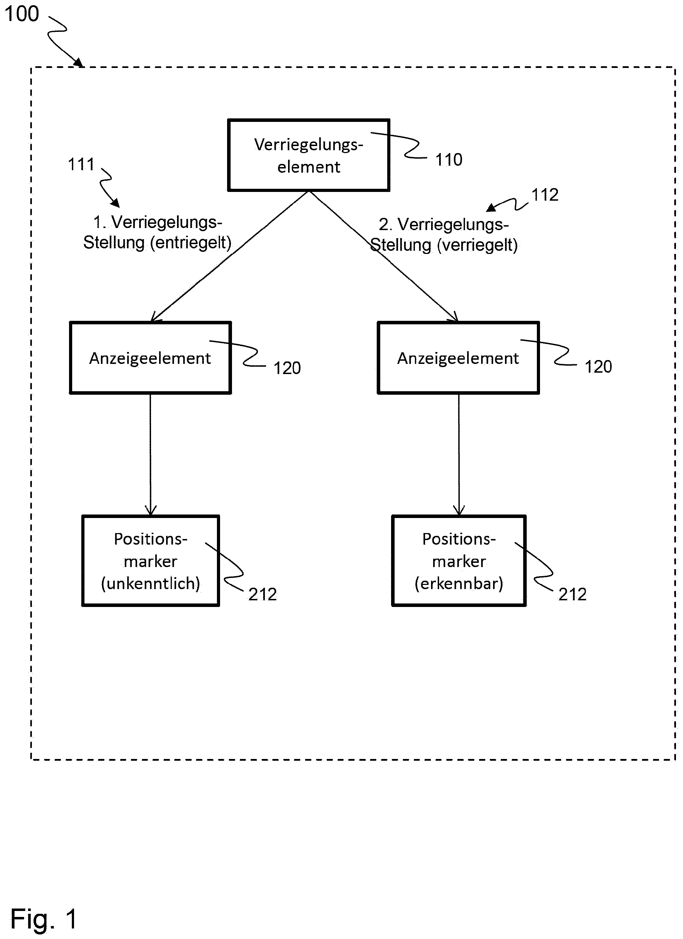

Fig. 1 zeigt eine schematische Darstellung der Zustände einer erfindungsgemäßen Sicherungsvorrichtung 100.

Die Sicherungsvorrichtung 100 dient zur Sicherung einer Verriegelung eines Verriegelungselements 110. Die Sicherungsvorrichtung 100 umfasst ein Verriegelungselement 110 und ein Anzeigeelement 120.

Das Verriegelungselement 110 ist von einer ersten Verriegelungsstellung 111 in eine zweite Verriegelungsstellung 112 bewegbar und bewirkt in der zweiten Verriegelungsstellung 112 eine Verriegelung.

Das Anzeigeelement 120 dient zum Anzeigen einer Information, beispielsweise einer Information über eine Verriegelung durch das Verriegelungselement 110, oder aber auch jeder anderer Information.

Das Anzeigeelement 120 weist einen oder mehrere Orientierungselemente 212 zum Markieren einer Position des Anzeigeelements 120 auf. Das Anzeigeelement 120 ist über die ein oder mehreren Orientierungselemente 212 erfassbar.

Die ein oder mehreren Orientierungselemente 212 sind in der ersten Verriegelungsstellung 111 des Verriegelungselements 110 zumindest teilweise unkenntlich gemacht, so dass das Anzeigeelement 120 nicht erfassbar ist.

Die ein oder mehreren Orientierungselemente 212 sind in der zweiten Verriegelungsstellung 112 des Verriegelungselements 110 kenntlich gemacht, so dass das Anzeigeelement 120 erfassbar ist.

Insbesondere sind die ein oder mehreren Orientierungselemente 212 in der ersten Verriegelungsstellung 111 unkenntlich gemacht, ohne die ein oder mehreren Orientierungselemente 212 zu verdecken.

Ausführungen des Anzeigeelements 120 mit Beschreibung, wie die Orientierungselemente 212 unkenntlich bzw. kenntlich gemacht werden können, ohne diese zu verdecken, sind näher zu den Figuren 2a, 2b, 3a und 3b beschrieben.

Die Figuren 2a und 2b zeigen eine 2D-Darstellung eines erfindungsgemäßen Anzeigeelements 120 mit unkenntlich (Fig. 2a) bzw. kenntlich (Fig. 2b) gemachten Orientierungselementen 212.

Das Anzeigeelement 120 weist ein Erkennungsmerkmal auf, beispielsweise einen ein-, zwei- oder mehrdimensionalen Code 200, beispielsweise einen DMC. Das Erkennungsmerkmal umfasst einen Datenbereich 211 zum Erfassen des Erkennungsmerkmals 200. Die ein oder mehreren Orientierungselemente 212 sind an einem Rand des Datenbereichs 211 angeordnet, wie in Figur 2a dargestellt. Das Erkennungsmerkmal 200 ist bei einer zumindest teilweisen Unkenntlichmachung der Orientierungselemente 212 nicht mehr erfassbar.

Das Erkennungsmerkmal 200 weist einen um den Datenbereich 211 und die Orientierungselemente 212 umlaufenden Ruhebereich 213 auf, wie in Figur 2b dargestellt. Der Ruhebereich 213 ist in der ersten Verriegelungsstellung 111 des Verriegelungselements 110 zumindest teilweise verdeckt und das Erkennungsmerkmal 200 ist dadurch nicht mehr kenntlich.

Das Anzeigeelement 120 weist einen um das Erkennungsmerkmal 200 umlaufenden Rand 220 auf, der die ein oder mehreren Orientierungselemente 212 unkenntlich macht, wie in Figur 2a dargestellt. In der zweiten Verriegelungsstellung 112 ist der Rand 220 von einem hellen Rahmen verdeckt, der die ein oder mehreren Orientierungselemente 212 wieder kenntlich macht.

Der Rand 220 weist eine gleiche oder ähnliche Farbe auf wie die Orientierungselemente 212, in Figur 2a eine schwarze Farbe, es kann aber auch eine andere dunkle Farbe sein. Der Rahmen weist eine Farbe auf, die in Kontrast zu der Farbe des Rands 220 steht, in Figur 2b ist das eine weiße Farbe, es kann aber auch eine andere helle Farbe sein.

Das Erkennungsmerkmal 200 kann ein Code sein, beispielsweise ein Data Matrix Code, DMC.

Ein solcher Data Matrix Code besteht beispielswies aus den folgenden Hauptkomponenten:
1) zwei Paare fester durchgehender und unterbrochener Kanten als Begrenzungslinien (Finder Pattern bzw. Orientierungselement bzw. Positionsmarker). Die festen Begrenzungslinien dienen zur Abgrenzung. Sie werden für die Ausrichtung und Entzerrung des Data Matrix Codes verwendet, so dass jeder Lesewinkel möglich ist.
2) eine umlaufende Ruhezone (Quiet Zone). Diese leere Zone umgibt den Data Matrix Code. Sie enthält keinerlei Informationen oder Muster. Die Breite der Ruhezone beträgt mindestens eine Spalte bzw. eine Zeile (besser die vierfache Breite bzw. Höhe eines Moduls) und wird zur Abgrenzung von anderen optischen Bildelementen der Umgebung benötigt.
3) die den geschlossenen Kanten gegenüberliegende Ecke. Diese Ecke erlaubt das schnelle Erkennen der Codeschemata. Beim Codeschema ECC 200 mit einer geraden Anzahl Zeilen und Spalten ist das Element in der oberen rechten Ecke stets weiß. Bei den anderen genormten Codeschemata mit einer ungeraden Zeilen- und Spaltenzahl ist das Element in der oberen rechten Ecke stets schwarz.
4) die Ausrichtungsmuster (Alignment Pattern). Diese paarweise Kombination durchgehender und unterbrochener Linien in beiden Richtungen waagerecht und senkrecht erleichtern die Bildauswertung. Sie unterteilen große Datenfelder bei Codes mit mindestens 32 Modulen Kantenlänge in gleich große Teile.
5) der Datenbereich. Dieser Datenbereich enthält die eigentliche binäre Information in kodierter Form. Je nach Größe der Matrix definiert sich damit auch die Anzahl der möglichen Informationen.

Die Figuren 3a und 3b zeigen eine 2D-Darstellung eines auf der CPA aufgebrachten erfindungsgemäßen Anzeigeelements 120 mit unkenntlich (Fig. 3a) bzw. kenntlich (Fig. 3b) gemachten Orientierungselementen 212.

Das Anzeigeelement 120 weist ein Erkennungsmerkmal 200 auf, beispielsweise einen ein-, zwei- oder mehrdimensionalen Code, beispielsweise einen DMC. Das Erkennungsmerkmal umfasst einen Datenbereich 211 zum Erfassen des Erkennungsmerkmals 200, wie oben zu den Figuren 2a und 2b dargestellt. Die ein oder mehreren Orientierungselemente 212 sind an einem Rand des Datenbereichs 211 angeordnet, wie in Figur 3a dargestellt. Wie bereits oben zu den Figuren 2a und 2b beschrieben, ist das Erkennungsmerkmal 200 bei einer zumindest teilweisen Unkenntlichmachung der Orientierungselemente 212 nicht mehr erfassbar.

Das Erkennungsmerkmal 200 weist einen um den Datenbereich 211 und die Orientierungselemente 212 umlaufenden Ruhebereich 213 auf, wie oben zu Figur 2b dargestellt. Der Ruhebereich 213 ist in der ersten Verriegelungsstellung 111 des Verriegelungselements 110 zumindest teilweise verdeckt und das Erkennungsmerkmal 200 ist dadurch nicht mehr kenntlich, wie in Figur 3a dargestellt.

Das Anzeigeelement 120 weist einen um das Erkennungsmerkmal 200 umlaufenden Rand 220 auf, der die ein oder mehreren Orientierungselemente 212 unkenntlich macht, wie in Figur 2a dargestellt. In der zweiten Verriegelungsstellung 112 ist der Rand 220 von einem hellen Rahmen 310 verdeckt, wie in Figur 3b dargestellt, der die ein oder mehreren Orientierungselemente 212 wieder kenntlich macht.

Der Rand 220 weist eine gleiche oder ähnliche Farbe auf wie die Orientierungselemente 212, in Figur 3a ebenso wie in Figur 2a eine schwarze Farbe, es kann aber auch eine andere dunkle Farbe sein. Der Rahmen 310 weist eine Farbe auf, die in Kontrast zu der Farbe des Rands 220 steht, in Figur 3b ist das ebenso wie in Figur 2b eine weiße Farbe, es kann aber auch eine andere helle Farbe sein.

Das Erkennungsmerkmal kann ein ein-, zwei- oder mehrdimensionaler Code sein, beispielsweise ein Data Matrix Code, DMC, wie oben beschrieben.

Das Anzeigeelement 120 kann an dem Verriegelungselement 110 angebracht sein, wobei eine Bewegung des Verriegelungselements 110 in die zweite Verriegelungsstellung 112 das Anzeigeelement 120 erfassbar macht entsprechend der Darstellung in Figur 3b.

Das Anzeigeelement 120 kann erkennbar sein und beispielsweise mit einem Lesegerät gelesen werden, beispielsweise einem scanbaren Element, wenn die ein oder mehreren Orientierungselemente 212 nicht zumindest teilweise unkenntlich gemacht sind.

Die Sicherungsvorrichtung 100 kann ausgebildet sein, eine Steckerpositions-Sicherung (CPA) zur Sicherung einer Verriegelung eines Steckergehäuses 400 an einem Gegen-Steckergehäuse 401 vorzunehmen, wie unten zu den Figur 4a bis 4c näher beschrieben.

Mit der Sicherungsvorrichtung 100 und einem Lesegerät kann ein Sicherungssystem implementiert werden, das den Zustand des Verriegelungselements 110 sicher bestimmen und zur weiteren Verarbeitung beispielsweise an eine Steuerung übertragen kann. Ein solches Sicherungssystem umfasst eine Sicherungsvorrichtung 100 wie oben beschrieben und ein Lesegerät. Das Lesegerät ist dabei ausgebildet, das Anzeigeelement 120 zu erfassen, wenn sich das Verriegelungselement 110 in der zweiten Verriegelungsstellung befindet, d.h., wenn das Anzeigeelement 120 erfassbar ist, um so eine Verriegelung zu erkennen.

Das Lesegerät kann dabei ausgebildet sein, das Anzeigeelement 120 nur dann zu erfassen, wenn sich das Verriegelungselement 110 in der zweiten Verriegelungsstellung 112 befindet und nur in dieser Stellung 112 eine korrekte Verriegelung zu erfassen.

Das Lesegerät kann die erfassten Informationen, beispielsweise den ausgelesenen Code an eine Steuerung weitergeben, die dann einen Fehler anzeigen kann und entsprechende Schritte ausführen kann, um den Herstellungsprozess zu steuern.

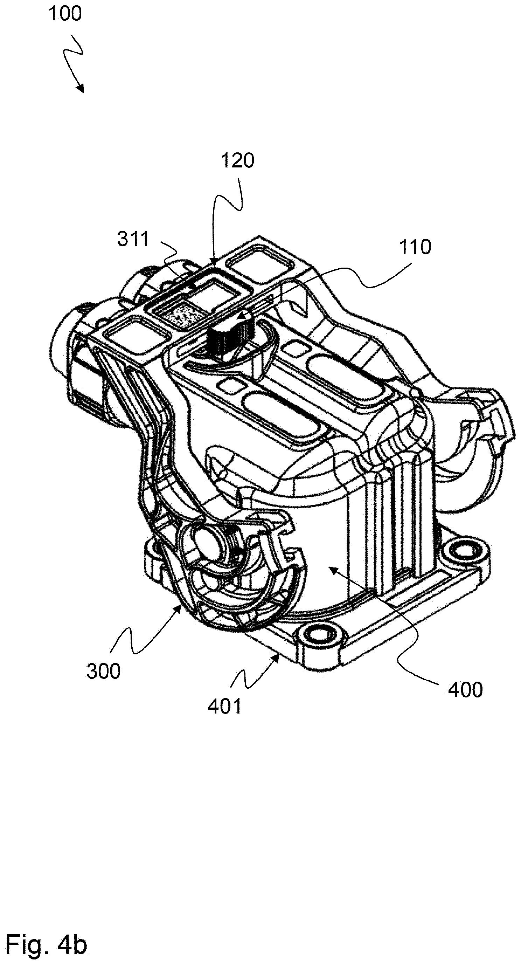

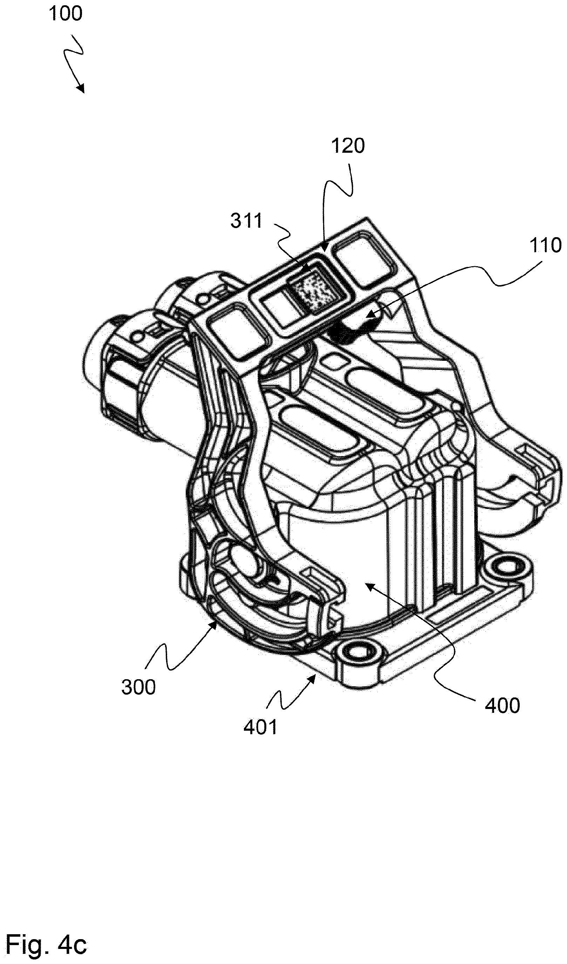

Die Figuren 4a, 4b und 4c zeigen 3D-Darstellungen einer Sicherungsvorrichtung 100 umfassend ein Verriegelungselement 110, ein Anzeigeelement 120 und ein Spannelement 300. In Figur 4a wird eine geschlossene Sicherungsvorrichtung 100 gemäß einer ersten Variante dargestellt, bei der sich das Spannelement 300 in geschlossener Spannbügelstellung befindet. In Figur 4b wird die Sicherungsvorrichtung 100 gemäß der ersten Variante in geöffneter Spannbügelstellung dargestellt. In Figur 4c wird eine geöffnete Sicherungsvorrichtung 100 gemäß einer zweiten Variante dargestellt, bei der sich das Spannelement 300 in geöffneter Spannbügelstellung befindet. Die erste Variante entspricht auch den Figuren 2a und 2b, während die zweite Variante den Figuren 3a und 3b entspricht.

Die Sicherungsvorrichtung 100 ist ausgebildet, eine Steckerpositions-Sicherung (CPA) zur Sicherung einer Verriegelung eines Steckergehäuses 400 an einem Gegen-Steckergehäuse 401 vorzunehmen.

Die Sicherungsvorrichtung 100 umfasst neben den bereits oben beschriebenen Verriegelungselement 110 und Anzeigeelement 120 auch ein Spannelement 300, beispielsweise einen Spannbügel, zum Einspannen des Steckergehäuses 400 in das Gegen-Steckergehäuse 401.

Das Spannelement 300 ist von einer offenen Spannelementstellung (siehe Figur 4a und 4c), in der das Steckergehäuse 400 in das Gegen-Steckergehäuse 401 einführbar ist, in eine geschlossene Spannelementstellung (siehe Figur 4b), in der das Steckergehäuse 400 elektrisch kontaktierend mit dem Gegen-Steckergehäuse 401 fixiert ist, bewegbar.

Das Verriegelungselement 110 ist an dem Spannelement 300 angebracht und ist ausgebildet, das Spannelement 300 zu verriegeln oder zu entriegeln.

Das Anzeigeelement 120 zeigt eine Information an, wenn sich das Verriegelungselement 110 in der zweiten Verriegelungsstellung 112 befindet, wie in Figur 4b dargestellt. Beim Anzeigen der Information liegt eine Verriegelung des Spannelements 300 durch das Verriegelungselement 110 vor.

Das Verriegelungselement 110 ist in der geschlossenen Spannelementstellung von der ersten Verriegelungsstellung 111 (siehe Figur 4a und 4c) in die zweite Verriegelungsstellung 112 (siehe Figur 4b) bewegbar. Das Verriegelungselement 110 ist ausgebildet, in der zweiten Verriegelungsstellung 112 das Spannelement 300 in der geschlossenen Spannelementstellung zu verriegeln, und in der ersten Verriegelungsstellung 111 das Spannelement 300 für eine Bewegung in die offene Spannelementstellung zu entriegeln.

Das Spannelement 300 weist eine Aussparung 311 auf, wie in den Figuren a bis 4c und auch in Figur 3a dargestellt.

Das Anzeigeelement 120 ist an dem Spannelement 300, beispielsweise an einer Tafel oder einem Mittensteg des Spannelements 300 angebracht. Auch das Verriegelungselement 110 ist an dem Spannelement 300 angebracht.

Bei einer Bewegung des Verriegelungselements 110 in die zweite Verriegelungsstellung 112 wird das Anzeigeelement 120 unter die Aussparung 311 des Spannelements bewegt, und damit die ein oder mehreren Orientierungselemente 212 kenntlich gemacht, so dass das Anzeigeelement 120 erfassbar ist.

In der ersten Variante gemäß den Figuren 4a und 4b ist das Erkennungsmerkmal 200 mit einem umlaufenden schwarzen Rahmen auf der CPA aufgebracht. Durch Betätigen der CPA wird diese unter den Bügel 300 geschoben. In dem Bügel 300 befindet sich eine Aussparung 311. Diese Aussparung 311 ist so ausgelegt, dass die Orientierungselemente 212 wieder klar erkennbar sind. Das Erkennungsmerkmal 200 wird nicht verdeckt. Es wird lediglich so dargestellt, dass die Orientierungselemente 212 nicht erkennbar sind in der ersten Verriegelungsstellung, wie in Figur 3a dargestellt. In der zweiten Verriegelungsstellung 112 sind die Orientierungselemente 212 des Erkennungsmerkmals 200 erkennbar, wie in Figur 4b dargestellt.

In der zweiten Variante gemäß Darstellung in Figur 4c wird um die Orientierungselemente 212 des Erkennungsmerkmals 200 ein zusätzlicher Rand geschoben, um die Erkennung zu verschleiern, wie aus Figur 4c ersichtlich.

Die Figuren 4a bis 4c zeigen somit auch eine Steckverbindung mit einem Steckergehäuse 400 und einem Gegen-Steckergehäuse 401, die über die Sicherungsvorrichtung 100 wie oben beschrieben miteinander verbunden und gesichert sind.

### BEZUGSZEICHENLISTE

- 100: Sicherungsvorrichtung
- 110: Verriegelungselement
- 111: erste Verriegelungsstellung (entriegelt)
- 112: zweite Verriegelungsstellung (verriegelt)
- 120: Anzeigeelement
- 200: Erkennungsmerkmal
- 211: Datenbereich des Erkennungsmerkmals
- 212: Orientierungselemente des Erkennungsmerkmals
- 213: Ruhebereich des Erkennungsmerkmals
- 220: umlaufender Rand des Anzeigeelements
- 310: Rahmen
- 300: Spannelement bzw. Spannbügel
- 311: Aussparung am Spannelement
- 400: Steckergehäuse
- 401: Gegen-Steckergehäuse

## Patentansprüche

1. Sicherungsvorrichtung (100) zur Sicherung einer Verriegelung eines Verriegelungselements (110), wobei die Sicherungsvorrichtung (100) Folgendes umfasst:
ein Verriegelungselement (110), das von einer ersten Verriegelungsstellung (111) in eine zweite Verriegelungsstellung (112) bewegbar ist, wobei das Verriegelungselement (110) in der zweiten Verriegelungsstellung (112) eine Verriegelung bewirkt; und
ein Anzeigeelement (120) zum Anzeigen einer Information, wobei das Anzeigeelement (120) in der ersten Verriegelungsstellung stets sichtbar und nicht verdeckt ist;
wobei das Anzeigeelement (120) einen oder mehrere Orientierungselemente (212) zum Markieren einer Orientierung des Anzeigeelements (120) aufweist, wobei das Anzeigeelement (120) über die ein oder mehreren Orientierungselemente (212) erfassbar ist;
wobei die ein oder mehreren Orientierungselemente (212) in der ersten Verriegelungsstellung (111) des Verriegelungselements (110) zumindest teilweise unkenntlich gemacht sind, so dass das Anzeigeelement (120) nicht erfassbar ist; und
wobei die ein oder mehreren Orientierungselemente (212) in der zweiten Verriegelungsstellung (112) des Verriegelungselements (110) kenntlich gemacht sind, so dass das Anzeigeelement (120) erfassbar ist.

2. Sicherungsvorrichtung (100) nach Anspruch 1,
wobei die ein oder mehreren Orientierungselemente (212) in der ersten Verriegelungsstellung (111) unkenntlich gemacht sind ohne die ein oder mehreren Orientierungselemente (212) zu verdecken.

3. Sicherungsvorrichtung (100) nach Anspruch 1 oder 2,
wobei das Anzeigeelement (120) ein Erkennungsmerkmal (200) mit einem Datenbereich (211) zum Erfassen des Erkennungsmerkmals (200) aufweist, wobei die ein oder mehreren Orientierungselemente (212) an einem Rand des Datenbereichs (211) angeordnet sind; und
wobei das Erkennungsmerkmal (200) bei einer zumindest teilweisen Unkenntlichmachung der Orientierungselemente (212) nicht mehr erfassbar ist.

4. Sicherungsvorrichtung (100) nach Anspruch 3,
wobei das Erkennungsmerkmal (200) einen um den Datenbereich (211) und die Orientierungselemente (212) umlaufenden Ruhebereich (213) umfasst,
wobei der Ruhebereich (213) in der ersten Verriegelungsstellung (111) des Verriegelungselements (110) zumindest teilweise verdeckt ist und das Erkennungsmerkmal (200) dadurch nicht mehr kenntlich ist.

5. Sicherungsvorrichtung (100) nach Anspruch 3 oder 4,
wobei das Anzeigeelement (120) einen um das Erkennungsmerkmal (200) umlaufenden Rand (220) aufweist, der die ein oder mehreren Orientierungselemente (212) unkenntlich macht;
wobei in der zweiten Verriegelungsstellung (112) der Rand (220) von einem Rahmen (310) verdeckt ist, der die ein oder mehreren Orientierungselemente (212) kenntlich macht.

6. Sicherungsvorrichtung (100) nach Anspruch 5,
wobei der Rand (220) eine gleiche oder ähnliche Farbe wie die Orientierungselemente (212) aufweist; und
wobei der Rahmen (310) eine Farbe aufweist, die in Kontrast zu der Farbe des Rands (220) steht.

7. Sicherungsvorrichtung (100) nach einem der vorstehenden Ansprüche,
wobei das Erkennungsmerkmal (200) einen Codeumfasst.

8. Sicherungsvorrichtung (100) nach einem der vorstehenden Ansprüche,
wobei das Anzeigeelement (120) an dem Verriegelungselement (110) angebracht ist und eine Bewegung des Verriegelungselements (110) in die zweite Verriegelungsstellung (112) das Anzeigeelement (120) erfassbar macht.

9. Sicherungsvorrichtung (100) nach einem der vorstehenden Ansprüche,
wobei das Anzeigeelement (120) erkennbar ist, wenn die ein oder mehreren Orientierungselemente (212) nicht zumindest teilweise unkenntlich gemacht sind.

10. Sicherungsvorrichtung (100) nach einem der vorstehenden Ansprüche,
wobei die Sicherungsvorrichtung (100) ausgebildet ist, eine Steckerpositions-Sicherung (CPA) zur Sicherung einer Verriegelung eines Steckergehäuses (400) an einem Gegen-Steckergehäuse (401) vorzunehmen.

11. Sicherungsvorrichtung (100) nach Anspruch 10, ferner umfassend:
ein Spannelement (300) zum Einspannen des Steckergehäuses (400) in das Gegen-Steckergehäuse (401), wobei das Spannelement (300) von einer offenen Spannelementstellung, in der das Steckergehäuse (400) in das Gegen-Steckergehäuse (401) einführbar ist, in eine geschlossene Spannelementstellung, in der das Steckergehäuse (400) elektrisch kontaktierend mit dem Gegen-Steckergehäuse (401) fixiert ist, bewegbar ist; und
wobei das Verriegelungselement (110) an dem Spannelement (300) angebracht ist und ausgebildet ist, das Spannelement (300) zu verriegeln oder zu entriegeln.

12. Sicherungsvorrichtung (100) nach Anspruch 11,
wobei das Verriegelungselement (110) in der geschlossenen Spannelementstellung von der ersten Verriegelungsstellung (111) in die zweite Verriegelungsstellung (112) bewegbar ist und ausgebildet ist, in der zweiten Verriegelungsstellung (112) das Spannelement (300) in der geschlossenen Spannelementstellung zu verriegeln, und in der ersten Verriegelungsstellung (111) das Spannelement (300) für eine Bewegung in die offene Spannelementstellung zu entriegeln.

13. Sicherungsvorrichtung (100) nach Anspruch 12,
wobei das Spannelement (300) eine Aussparung (311) aufweist;
wobei das Anzeigeelement (120) an dem Spannelement (300) angebracht ist; und
wobei bei einer Bewegung des Verriegelungselements (110) in die zweite Verriegelungsstellung (112) das Anzeigeelement (120) unter die Aussparung (311) des Spannelements (300) bewegt wird, und damit die ein oder mehreren Orientierungselemente (212) kenntlich macht, so dass das Anzeigeelement (120) erfassbar ist.
